# EUROPEAN PATENT APPLICATION

(11) **EP 3 923 338 A2**
(43) Date of publication of application: **15.12.2021**
(21) Application number: 21177441.9
(22) Date of filing: 02.06.2021
(51) Int. Cl.: H01L 27/32, H01L 51/00, H01L 51/52

(54) **DISPLAY DEVICE, AND METHOD OF MANUFACTURING A DISPLAY DEVICE**

(30) Priority: 04.06.2020 KR 20200067710
(71) Applicant: Samsung Display Co., Ltd., Yongin-si, Gyeonggi-Do 17113 (KR)
(72) Inventor: AHN, Jea Heon, Hwaseong-si (KR); OH, Keun Chan, Hwaseong-si (KR); KIM, Jeong Ki, Hwaseong-si (KR); KIM, Jong-Hoon, Seoul (KR); YANG, Ji Seong, Suwon-si (KR)
(74) Representative: Shearman, James Ward

(57) **Abstract**

A display device includes a substrate including a light emitting area and a light blocking area that surrounds the light emitting area, and a bank structure disposed in the light blocking area and having an opening that corresponds to the light emitting area. The bank structure has a concave portion that is formed on an upper surface.

## Description

### BACKGROUND

### 1. Field

The present disclosure relates to a display device, and more particularly to a display device including a bank structure.

### 2. Description of the Related Art

The organic light emitting display device is capable of emitting light by itself, and may generate a color image without a separate light source such as a backlight.

Recently, the organic light emitting display device including an organic light emitting diode and a color converting layer has been developed. The color converting layer may convert a wavelength of light provided by the light emitting diode. Accordingly, light having a color that is different from the color of incident light may be emitted.

The organic light emitting diode and the color converting layer may be formed by an ink jet process. During the ink jet process, ink may be applied between bank structures that serve as wells. However, the ink may not be applied accurately between the bank structures and may be erroneously applied on the bank structure. In this case, a separate layer disposed on the bank structure may have a non-uniform height so that a gap defect may occur in the organic light emitting display device.

### SUMMARY

The present disclosure provides a display device capable of preventing a gap defect.

Some embodiments of the present disclosure provide a method of manufacturing a display device that is capable of preventing a gap defect.

According to one embodiment, a display device includes a substrate including a light emitting area and a light blocking area that surrounds the light emitting area and a bank structure disposed in the light blocking area and having an opening that corresponds to the light emitting area, and the bank structure has a concave portion on an upper surface.

In one embodiment, the concave portion may reach an upper surface of the substrate.

In one embodiment, the concave portion may be spaced apart from an upper surface of the substrate.

In one embodiment, the display device may further include an organic light emitting diode disposed in the opening, and the organic light emitting diode may include a lower electrode, a light emitting layer disposed on the lower electrode and an upper electrode disposed on the light emitting layer.

In one embodiment, the display device may further include a color converting layer disposed in the opening, and the color converting layer may include a wavelength converting particle and a resin portion.

In one embodiment, the bank structure may include a light blocking material.

In one embodiment, the display device may further include a color filter layer overlapping the color converting layer and a light blocking layer overlapping the bank structure.

In one embodiment, the color filter layer may be disposed between the color converting layer and the substrate, and the light blocking layer may be disposed between the bank structure and the substrate.

According to one embodiment, a display device includes a substrate including a light emitting area and a light blocking area that surrounds the light emitting area and a bank structure disposed in the light blocking area and having an opening that corresponds to the light emitting area, and the bank structure has a concave portion on an upper surface, and the bank structure includes a first portion and a second portion that is disposed on the first portion and includes the concave portion.

In one embodiment, the concave portion may reach an upper surface of the first portion.

In one embodiment, the concave portion may be spaced apart from an upper surface of the substrate.

In one embodiment, the display device may further include an organic light emitting diode disposed in the opening, and the organic light emitting diode may include a lower electrode, a light emitting layer disposed on the lower electrode and an upper electrode disposed on the light emitting layer.

In one embodiment, the display device may further include a color converting layer disposed in the opening, and the color converting layer may include a wavelength converting particle and a resin portion.

In one embodiment, the bank structure may include a light blocking material.

In one embodiment, the display device may further include a color filter layer overlapping the color converting layer and a light blocking layer overlapping the bank structure.

In one embodiment, the color filter layer may be disposed between the color converting layer and the substrate, and the light blocking layer may be disposed between the bank structure and the substrate.

According to one embodiment, a method of manufacturing a display device includes: preparing a substrate including a light emitting area and a light blocking area that surrounds the light emitting area; forming a bank structure having an opening on the substrate, wherein the opening corresponds to the light emitting area of the substrate; forming a concave portion on an upper surface of the bank structure; applying an ink into the opening; and drying or curing the ink.

In one embodiment, the ink may contain an organic light emitting material.

In one embodiment, the ink may contain a wavelength converting particle.

In one embodiment, forming the bank structure may include: forming a first portion of the bank structure on the substrate; and forming a second portion of the bank structure having the concave portion on the first portion.

At least some of the above and other features of the invention are set out in the claims.

As described above, the display device of the present disclosure may include a substrate including a light emitting area and a light blocking area that surrounds the light emitting area and a bank structure disposed in the light blocking area having an opening that corresponds to the light emitting area, and having a concave portion on an upper surface.

Accordingly, ink erroneously applied on the bank structures may be accommodated in the concave portion. As a result, gap defects that may be caused by erroneously applying the ink on the bank structure may be prevented.

### BRIEF DESCRIPTION OF THE DRAWINGS

Illustrative, non-limiting embodiments of the present disclosure will be more clearly understood from the following detailed description in conjunction with the accompanying drawings.
FIG. 1 is a plan view illustrating a display device according to an embodiment of the present disclosure.
FIG. 2 is a cross-sectional view illustrating an embodiment taken along line I-I' of FIG. 1.
FIG. 3 is a cross-sectional view illustrating an embodiment of forming an organic light emitting diode using an inkjet device.
FIG. 4 is a cross-sectional view illustrating an embodiment of forming a color converting layer using an inkjet device.
FIG. 5 is a cross-sectional view illustrating an embodiment of a bank structure of FIG. 2.
FIG. 6 is a cross-sectional view illustrating another embodiment of the bank structure of FIG. 2.
FIG. 7 is a cross-sectional view illustrating yet another embodiment of the bank structure of FIG. 2.
FIG. 8 is a cross-sectional view illustrating yet another embodiment of the bank structure of FIG. 2.
FIGS. 9A, 9B, 9C, and 9D are diagrams illustrating a method of manufacturing a display device according to an embodiment of the present disclosure.
FIGS. 10A, 10B, 10C, 10D, and 10E are diagrams illustrating a method of manufacturing a display device according to an embodiment of the present disclosure.

### DETAILED DESCRIPTION OF THE EMBODIMENTS

Hereinafter, embodiments of the present disclosure will be explained in detail with reference to the accompanying drawings.

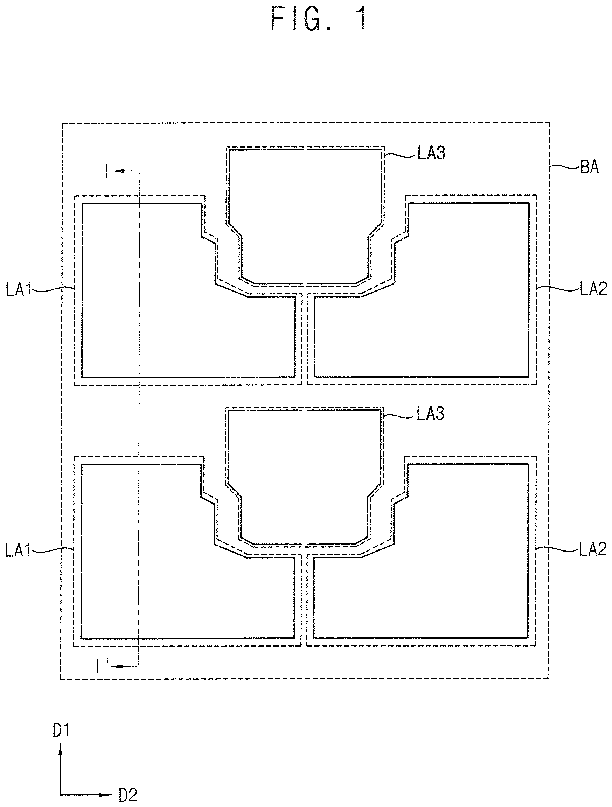

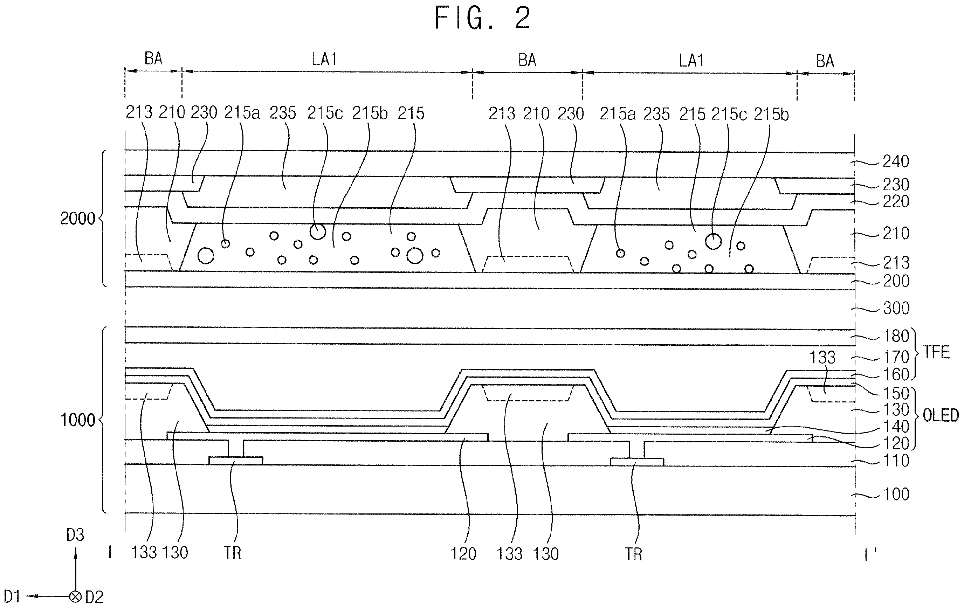

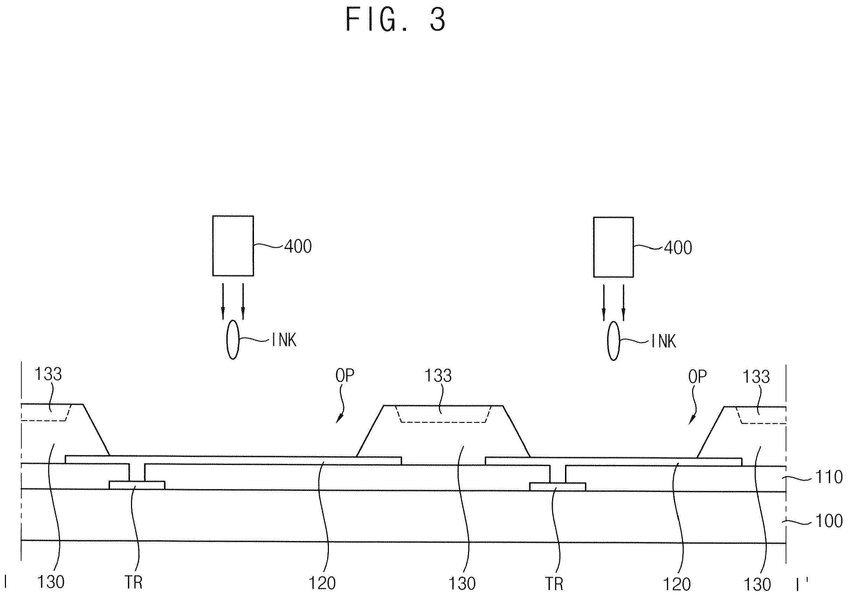

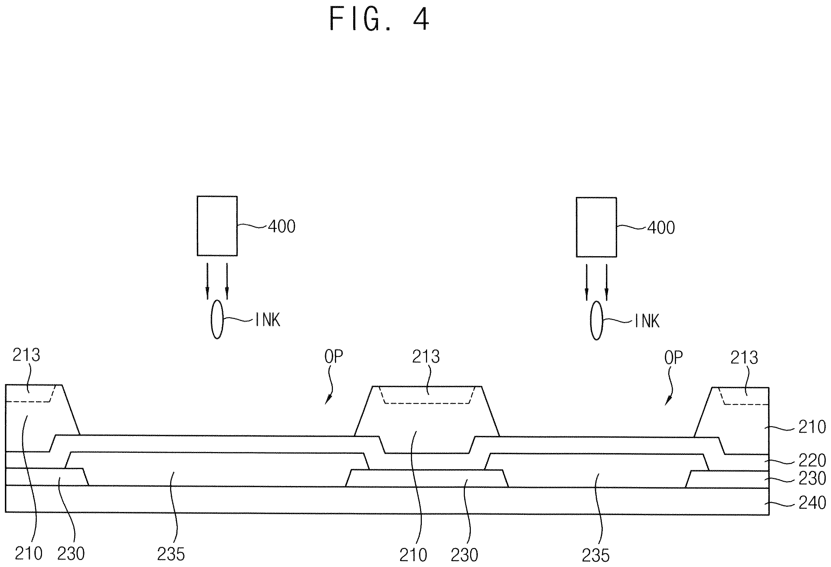

FIG. 1 is a plan view illustrating a display device according to an embodiment of the present disclosure, FIG. 2 is a cross-sectional view illustrating an embodiment taken along line I-I' of FIG. 1, FIG. 3 is a cross-sectional view illustrating an embodiment of forming an organic light emitting diode using an inkjet device, and FIG. 4 is a cross-sectional view illustrating an embodiment of forming a color converting layer using an inkjet device.

Referring to FIGS. 1 to 4, the display device may include a first substrate 1000 and a second substrate 2000. The first substrate 1000 may include an array of pixels. Each pixel of the pixel array may include a light emitting diode that emits light according to a driving signal. A liquid crystal layer 300 may be disposed between the first substrate 1000 and the second substrate 2000.

The second substrate 2000 may include a color converting layer 215 that converts a wavelength of light emitted from the light emitting diode. In addition, the second substrate 2000 may include a color filter that transmits light of a specific color.

The display device may include a display area displaying an image and a peripheral area that surrounds the display area. The display area may include a plurality of light emitting areas that emit light, and a light blocking area BA that surrounds the light emitting areas. Light emitted by the display device may be displayed to the outside through the light emitting areas.

The light emitting areas may emit light of different colors. For example, the display device may include a first light emitting area LA1 that emits first color light, a second light emitting area LA2 that emits second color light, and a third light emitting area LA3 that emits third color light.

In an embodiment, the first light emitting area LA1 may emit red light, the second light emitting area LA2 may emit blue light, and the third light emitting area LA3 may emit green light. However, the present disclosure is not limited thereto. For example, the light emitting areas LA1, LA2, and LA3 may emit light of yellow, cyan, and magenta colors.

In an embodiment, the light emitting areas that emit light of the same color may be arranged along a first direction D1. The light emitting areas that emit light of different colors may be arranged along a second direction D2 that intersects with the first direction D1. For example, the first direction D1 may be a column direction, and the second direction D2 may be a row direction.

In an embodiment, the first light emitting area LA1, the second light emitting area LA2, and the third light emitting area LA3 may be shifted along the column direction to have different center lines in the row direction. However, the present disclosure is not limited thereto, and the light emitting areas LA1, LA2, and LA3 may be aligned to have the same center line in the row direction.

In an embodiment, the light emitting areas LA1, LA2, and LA3 may emit light of four or more colors. For example, the light emitting areas LA1, LA2, and LA3 may further emit at least one of yellow, cyan, and magenta lights in addition to red, green, and blue lights. Further, the light emitting areas LA1, LA2, and LA3 may be combined to emit white light.

In an embodiment, the light emitting areas LA1, LA2, and LA3 may have different shapes. However, the present disclosure is not limited thereto. For example, the light emitting areas LA1, LA2, and LA3 may have the same shape. In addition, the light emitting areas LA1, LA2, and LA3 may have various shapes such as a square, a rhombus, a triangle, and a circle, and an edge or a corner of each pixel may have a round shape or a chamfered shape.

In an embodiment, the light emitting areas LA1, LA2, and LA3 may have different sizes. For example, the first light emitting area LA1 emitting red light and the third light emitting area LA3 emitting green light may have larger areas than the second light emitting area LA2 that emits blue light. However, the present disclosure is not limited thereto, and the light emitting areas LA1, LA2, and LA3 may have the same area.

Referring to FIG. 2, the first substrate 1000 may include a first base substrate 100, a driving element TR that is disposed on the first base substrate 100, and an insulating layer 110. The driving element TR may be electrically connected to a light emitting diode. In FIG. 2, an organic light emitting diode OLED is illustrated as an example of the light emitting diode. The organic light emitting diode OLED may include a lower electrode 120, a light emitting layer 140 disposed on the lower electrode 120, and an upper electrode 150 disposed on the light emitting layer 140.

The first base substrate 100 may include glass, quartz, sapphire, or a polymer material.

In an embodiment, the driving element TR may include a thin film transistor. The display device may include a plurality of thin film transistors.

A channel layer of the thin film transistor may include amorphous silicon, polycrystalline silicon, or a metal oxide semiconductor. Examples of the metal oxide semiconductor may include, but are not limited to, indium ("In"), zinc ("Zn"), gallium ("Ga"), tin ("Sn"), titanium ("Ti"), aluminium ("Al"), hafnium ("Hf"), zirconium ("Zr"), magnesium ("Mg"), and the like. Examples of the metal oxide semiconductor may include, but are not limited to, zinc oxide ("ZnOₓ"), gallium oxide ("GaOₓ"), titanium oxide ("TiOₓ"), tin oxide ("SnOₓ"), indium oxide ("InOₓ"), indium-gallium oxide ("IGO"), indium-zinc oxide ("IZO"), indium-tin oxide ("ITO"), gallium-zinc oxide ("GZO"), zinc-magnesium oxide ("ZMO"), zinc-tin oxide ("ZTO"), zinc-zirconium oxide ("ZnZrₓO_{y}"), indium-gallium-zinc oxide ("IGZO"), indium-zinc-tin oxide ("IZTO"), indium-gallium-hafnium oxide ("IGHO"), tin-aluminium-zinc oxide ("TAZO"), and indium-gallium-tin oxide ("IGTO"), and the like.

The insulating layer 110 may cover the driving element TR. The insulating layer 110 may include at least one inorganic insulating layer and at least one organic insulating layer.

The lower electrode 120 may correspond to an anode of the organic light emitting diode OLED. The lower electrode 120 may be a transmissive electrode or a reflective electrode according to a light emitting type of the display device. The lower electrode 120 serving as a reflective electrode may include gold ("Au"), silver ("Ag"), aluminium ("Al"), copper ("Cu"), nickel ("Ni"), platinum ("Pt"), magnesium ("Mg"), chromium ("Cr"), tungsten ("W"), molybdenum ("Mo"), titanium ("Ti"), or the like, and may further include a metal oxide layer such as indium-tin oxide, and indium-zinc oxide.

A bank structure may be disposed on the insulating layer 110 to cover at least a portion of the lower electrode 120. In an embodiment, in FIG. 2, a pixel defining layer 130 may correspond to the bank structure. The pixel defining layer 130 may include a space capable of accommodating ink that may be erroneously applied by an ink jet device 400 shown in FIGS. 3 and 4 in a process of forming the organic light emitting diode OLED. In an embodiment, the pixel defining layer 130 may have a concave portion 133. In addition, the pixel defining layer 130 may have an opening OP that exposes a portion of the lower electrode 120. At least a portion of the organic light emitting diode OLED may be disposed in the opening OP. The pixel defining layer 130 may include an organic insulating material. Description of the bank structure will be described later in detail with reference to FIGS. 3 to 6.

The light emitting layer 140 may include a single layer or a multilayer structure that includes at least one of functional layers such as a hole injection layer (HIL), a hole transport layer (HTL), an organic light emitting layer, an electron transport layer (ETL), and an electron injection layer (EIL). The light emitting layer 140 may include a low molecular weight organic compound or a high molecular weight organic compound. The light emitting layer 140 may generate light of various colors. For example, the light emitting layer 140 may generate light having one of blue, green, and red colors. In an embodiment, the light emitting layer 140 may be disposed in the opening OP of the pixel defining layer 130 by an inkjet process.

The upper electrode 150 may be a transmissive electrode or a reflective electrode according to a light emitting type of the display device. For example, the upper electrode 150 may include a metal, an alloy, a metal nitride, a metal fluoride, a conductive metal oxide, or any combination thereof. For example, the upper electrode 150 may extend continuously in the display area across a plurality of pixels.

The first substrate 1000 may further include an encapsulation layer TFE that is disposed on the upper electrode 150. The encapsulation layer TFE may continuously extend to cover the entire display area.

The encapsulation layer TFE may include a plurality of layers. For example, the encapsulation layer TFE may include a stacked structure of an organic thin film and an inorganic thin film. For example, in the embodiment shown in FIG. 2, the encapsulation layer TFE may include a first inorganic thin film 160, an organic thin film 170 disposed on the first inorganic thin film 160, and a second inorganic thin film 180 disposed on the organic thin film 170. However, the present disclosure is not limited thereto, and the encapsulation layer TFE may include a structure including two or more organic thin films and three or more inorganic thin films.

The organic thin film 170 may include a cured polymer such as polyacrylate. For example, the cured polymer may be formed by a crosslinking reaction of a monomer. The first and second inorganic thin films 160 and 180 may include silicon oxide, silicon nitride, silicon carbide, aluminium oxide, tantalum oxide, hafnium oxide, zirconium oxide, titanium oxide, or the like.

The second substrate 2000 may include the color converting layer 215 that converts a wavelength of light emitted from the organic light emitting diode OLED of the first substrate 1000. In addition, the second substrate 2000 may further include a second base substrate 240, a color filter layer 235 overlapping the color converting layer 215, a light blocking layer 230 overlapping the light blocking area BA, a partition wall 210, and a filling layer 200. In an embodiment, the filling layer 200 may be disposed on the liquid crystal layer 300 and may contact the liquid crystal layer 300.

The color filter layer 235 may be disposed between the second base substrate 240 and the color converting layer 215. The color filter layer 235 may transmit light of a specific color by filtering light passing through the color filter layer 235. In an embodiment, the color filter layer 235 may overlap the first light emitting area LA1. For example, the color filter layer 235 may transmit red light. The light blocking layer 230 may be formed in the light blocking area BA. In an embodiment, the light blocking layer 230 may partially overlap the color filter layer 235. For example, the light blocking layer 230 may include one or more of a metal, an alloy, an insulating inorganic material, and an organic material. The light blocking layer 230 may include a silicon-germanium alloy, germanium, titanium oxide, or the like. The light blocking layer 230 may include a light blocking material such as a pigment, a dye, or carbon black.

The second substrate 2000 may further include a protective layer 220 that overlaps the light blocking layer 230. The protective layer 220 may include an inorganic material such as silicon oxide or silicon nitride.

The color converting layer 215 may include wavelength converting particles 215a and a resin portion 215b. For example, the wavelength converting particles 215a may include quantum dots. The quantum dots may be a semiconductor material having nano crystals. The quantum dots may have a band gap depending on their composition and size. Accordingly, the quantum dots may absorb incident light and emit light having a wavelength different from that of the incident light. For example, the quantum dots may include a group II-VI compound, a group III-V compound, a group IV-VI compound, a group IV element, a group IV compound, and/or any combination thereof.

For example, the quantum dots may have a core/shell structure including a core and a shell that surrounds the core. For example, the core and the shell may include different materials.

The quantum dots may be dispersed in the resin portion 215b. For example, the resin portion 215b may include an epoxy resin, an acrylic resin, a phenol resin, a melamine resin, a cardo resin, an imide resin, or the like.

The color converting layer 215 may further include a scattering material 215c. The scattering material 215c may scatter the incident light without substantially changing the wavelength of the incident light.

The scattering material 215c may include a metal oxide or an organic material. For example, the metal oxide may include titanium oxide ("TiO₂"), zirconium oxide ("ZrO₂"), aluminium oxide ("Al₂O₃"), indium oxide ("In₂O₃"), zinc oxide ("ZnO"), tin oxide ("SnO₂"), or the like, and the organic material may include an acrylic resin or a urethane resin.

The second substrate 2000 may include a bank structure surrounding the color converting layer 215. In FIG. 2, the partition wall 210 may correspond to the bank structure. The partition wall 210 may include a space capable of accommodating ink that may be erroneously applied by the inkjet device 400 shown in FIGS. 3 and 4 in a process of forming the color converting layer 215. In an embodiment, the partition wall 210 may have a concave portion 213. In an embodiment, the partition wall 210 may include an organic material such as an epoxy resin, a phenolic resin, an acrylic resin, or a silicone resin.

In an embodiment, the partition wall 210 may include a light blocking material to serve as a black matrix. For example, at least a portion of the partition wall 210 may include a light blocking material such as a pigment, a dye, or carbon black. For example, the partition wall 210 may overlap at least a portion of the light blocking area BA.

The filling layer 200 may be disposed on the partition wall 210. The filling layer 200 may include an inorganic material such as silicon oxide or silicon nitride.

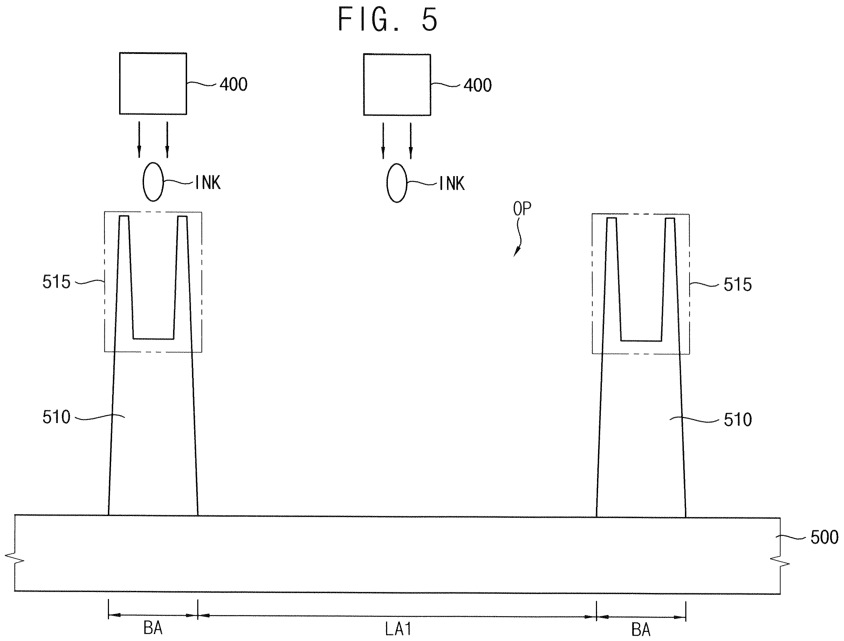

FIG. 5 is a cross-sectional view illustrating an embodiment of a bank structure of FIG. 2.

Referring to FIGS. 2 and 5, the display device may include a substrate 500 and a bank structure 510. The bank structure 510 may be disposed in the light blocking area BA of the substrate 500. The bank structure 510 may have the opening OP that corresponds to the first light emitting area LA1. In FIGS. 2 and 5, the bank structure 510 is illustrated as a non-limiting example to have the opening OP corresponding to the first light emitting area LA1, but the bank structure 510 may further have an opening corresponding to the second light emitting area LA2 and/or the third light emitting area LA3 without deviating from the scope of the present disclosure.

In an embodiment, the substrate 500 may include the first base substrate 100 and the insulating layer 110 of the first substrate 1000 shown in FIG. 2, and the bank structure 510 may correspond to the pixel defining layer 130 of the first substrate 1000 shown in FIG. 2. In another embodiment, the substrate 500 may include the second base substrate 240, the light blocking layer 230, the color filter layer 235, and the protective layer 220 of the second substrate 2000 shown in FIG. 2, and the bank structure 510 may correspond to the partition wall 210 of the second substrate 2000 shown in FIG. 2.

In an embodiment, the bank structure 510 may include a concave portion 515. The concave portion 515 may be formed on an upper surface of the bank structure 510. The concave portion 515 may be formed to be concave in the thickness direction of the substrate 500. The concave portion 515 may be spaced apart from the upper surface of the substrate 500.

In an embodiment, the organic light emitting diode OLED may be formed in the opening OP of the bank structure 510 by an inkjet process. In an embodiment, the color converting layer 215 of the second substrate 2000 shown in FIG. 2 may be formed in the opening OP of the bank structure 510 by the inkjet process.

The concave portion 515 of the bank structure 510 may accommodate ink that may be erroneously applied by the inkjet device 400 in an ink jet process. Accordingly, a gap defect that may otherwise occur when forming a separate layer on the bank structure 510 may be prevented.

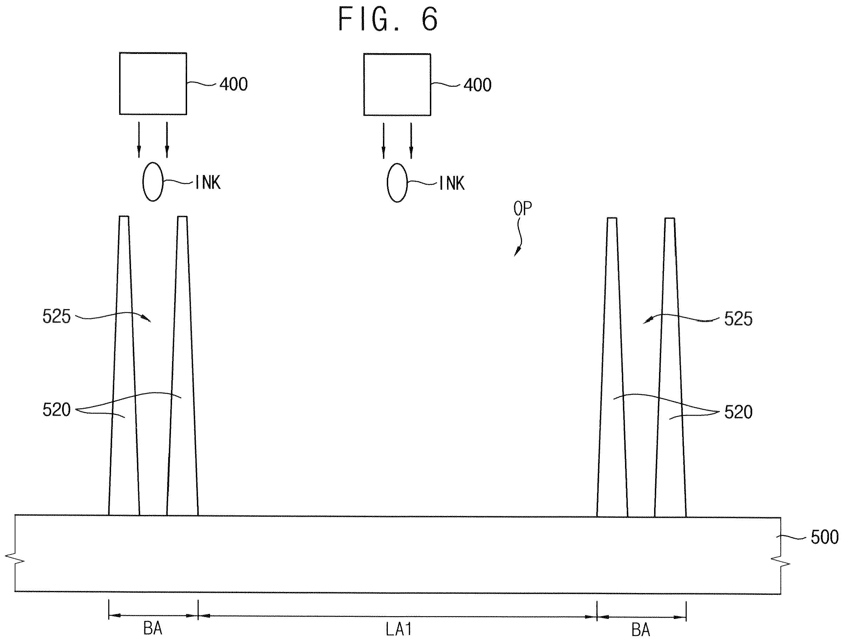

FIG. 6 is a cross-sectional view illustrating another embodiment of the bank structure of FIG. 2. The bank structure of FIG. 6 may be substantially the same as the bank structure of FIG. 5 except for the structure of the concave portion. Therefore, description of the overlapping configuration will be omitted.

Referring to FIGS. 2 and 6, the display device may include the substrate 500 and a bank structure 520. The bank structure 520 may include a concave portion 525. The concave portion 525 may be formed on an upper surface of the bank structure 520. The concave portion 525 may be formed to be concave in the thickness direction of the substrate 500. The concave portion 525 may reach an upper surface of the substrate 500.

The concave portion 525 of the bank structure 520 may accommodate ink that may be erroneously applied by the inkjet device 400 in the ink jet process. Accordingly, a gap defect that may otherwise occur when forming a separate layer on the bank structure 520 may be prevented.

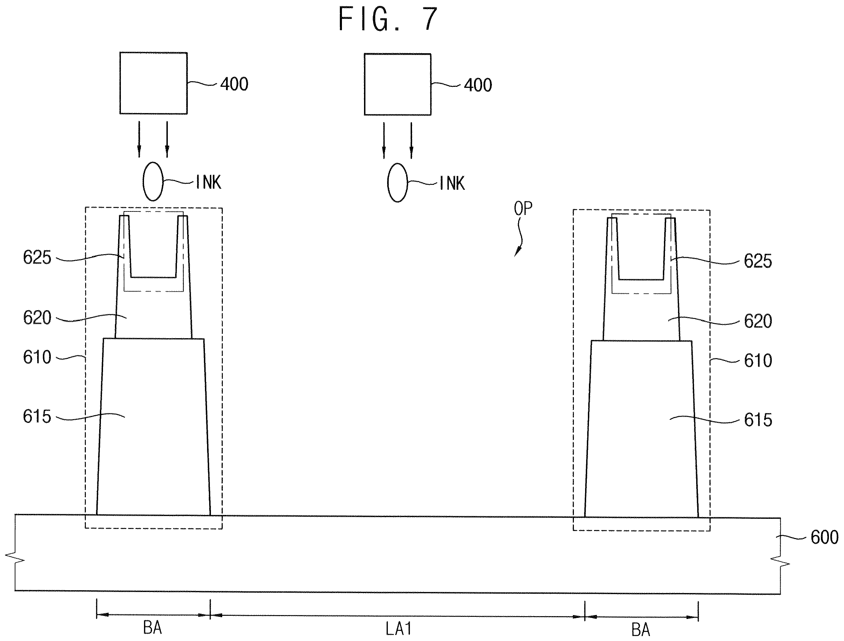

FIG. 7 is a cross-sectional view illustrating yet another embodiment of the bank structure of FIG. 2.

Referring to FIGS. 2 and 7, the display device may include a substrate 600 and a bank structure 610. The bank structure 610 may have a dual bank structure. The bank structure 610 may be disposed in the light blocking area BA of the substrate 600. The bank structure 610 may include a first portion 615 and a second portion 620. The first portion 615 may be disposed on the substrate 600, and the second portion 620 may be disposed on the first portion 615. The second portion 620 may include a material that is different from that of the first portion 615. For example, the second portion 620 may have an ink repellency that is different from that of the first portion 615. The second portion 620 may have a width that is narrower than the width of the first portion 615. For example, a bottom surface of the second portion 620 and an upper surface of the first portion 615 contact each other, and the bottom surface of the second portion 620 has a narrower width than the upper surface of the first portion 615.

In an embodiment, the bank structure 610 may have the opening OP corresponding to the first light emitting area LA1. In FIGS. 2 and 7, the bank structure 610 is illustrated as a non-limiting example to have the opening OP corresponding to the first light emitting area LA1, but the bank structure 610 may further have an opening corresponding to the second light emitting area LA2 and/or the third light emitting area LA3 without deviating from the scope of the present disclosure.

In an embodiment, the substrate 600 may include the first base substrate 100 and the insulating layer 110 of the first substrate 1000 shown in FIG. 2, and the bank structure 610 may correspond to the pixel defining layer 130 of the first substrate 1000 shown in FIG. 2. In another embodiment, the substrate 600 may include the second base substrate 240, the light blocking layer 230, the color filter layer 235, and the protective layer 220 of the second substrate 2000 shown in FIG. 2, and the bank structure 610 may correspond to the partition wall 210 of the second substrate 2000 shown in FIG. 2.

In an embodiment, the bank structure 610 may include a concave portion 625. The concave portion 625 may be formed on an upper surface of the second portion 620. The concave portion 625 may be formed to be concave in the thickness direction of the substrate 600. The concave portion 625 may be spaced apart from the upper surface of the first portion 615.

In an embodiment, the organic light emitting diode OLED may be formed in the opening OP of the bank structure 610 by the inkjet process. In an embodiment, the color converting layer 215 of the second substrate 2000 shown in FIG. 2 may be formed in the opening OP of the bank structure 610 by the inkjet process.

The concave portion 625 of the bank structure 610 may accommodate ink that may be erroneously applied by the inkjet device 400 in the ink jet process. Accordingly, a gap defect that may otherwise occur when forming a separate layer on the bank structure 610 may be prevented.

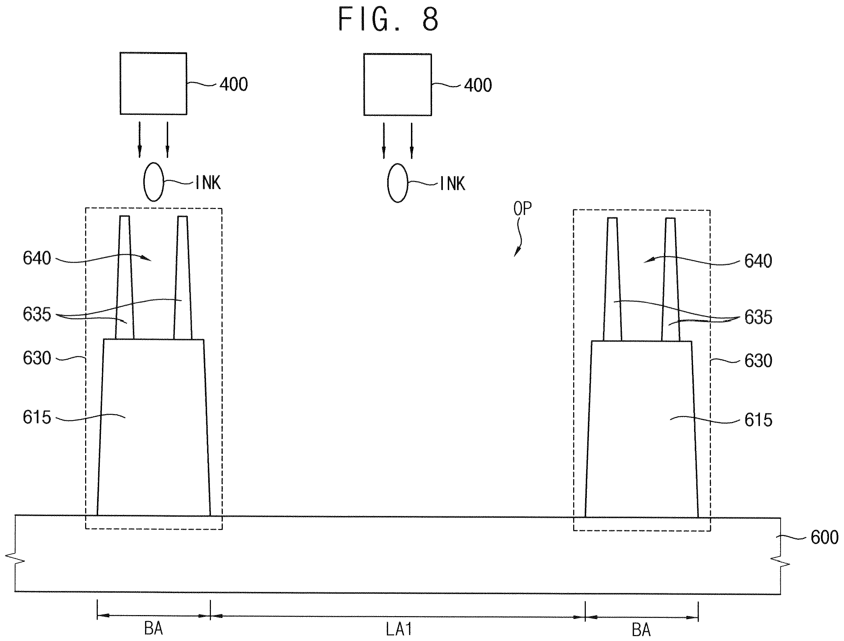

FIG. 8 is a cross-sectional view illustrating yet another embodiment of the bank structure of FIG. 2. The bank structure of FIG. 8 may be substantially the same as the bank structure of FIG. 7 except for the structure of the concave portion. Therefore, description of the overlapping configuration will be omitted.

Referring to FIGS. 2 and 8, the display device may include the substrate 600 and a bank structure 630. The bank structure 630 may include the first portion 615 and a second portion 635. The second portion 635 may have a concave portion 640. The second portion 635 may include a material that is different from that of the first portion 615. For example, the second portion 635 may have an ink repellency that is different from that of the first portion 615. The concave portion 640 may be formed on an upper surface of the bank structure 630. The concave portion 640 may be formed to be concave in the thickness direction of the substrate 600. The concave portion 640 may reach an upper surface of the first portion 615.

The concave portion 640 of the bank structure 630 may accommodate ink that may be erroneously applied by the inkjet device 400 in the ink jet process. Accordingly, a gap defect that may otherwise occur when forming a separate layer on the bank structure 630 may be prevented.

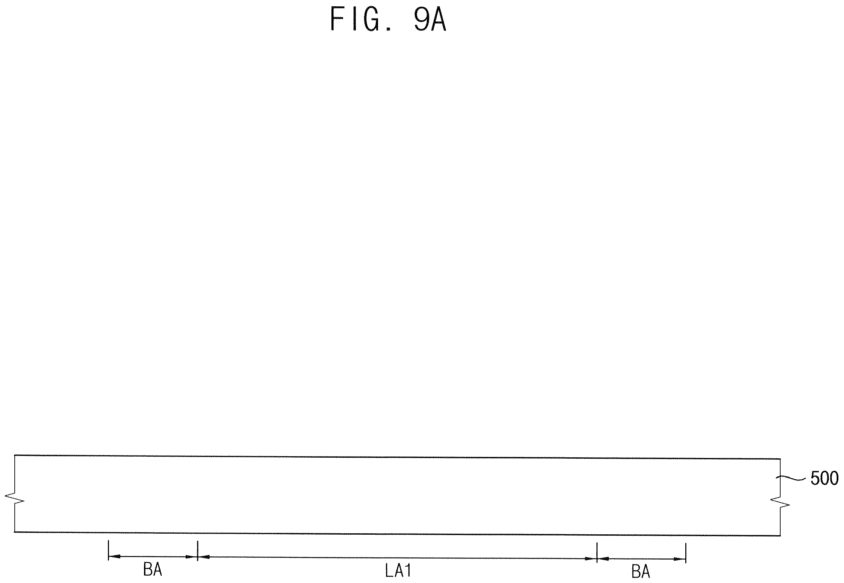

FIGS. 9A through 9D are diagrams illustrating a method of manufacturing a display device according to an embodiment of the present disclosure.

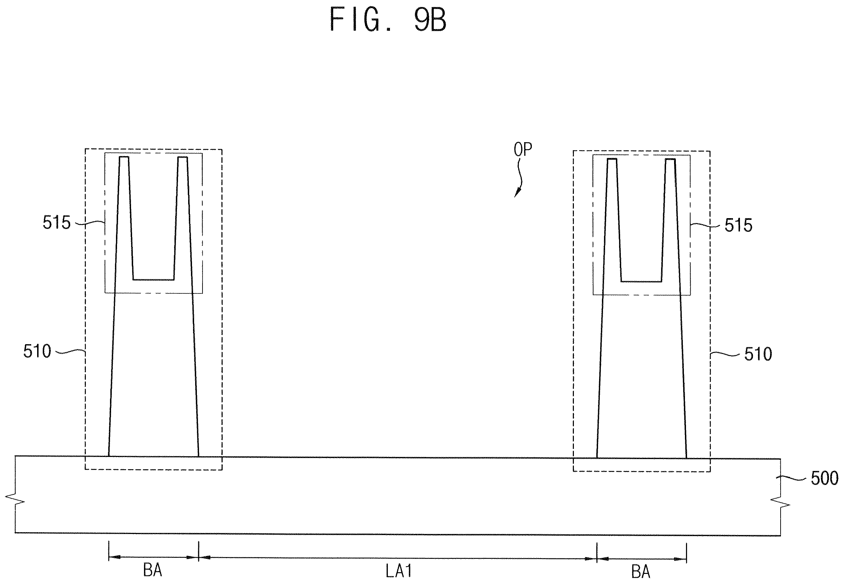

Referring to FIGS. 2, 9A, and 9B, the substrate 500 including the first light emitting area LA1 and the light blocking area BA that surrounds the light emitting area LA1 may be prepared. In an embodiment, the substrate 500 may include the first base substrate 100 and the insulating layer 110 of the first substrate 1000 shown in FIG. 2. In another embodiment, the substrate 500 may include the second base substrate 240, the light blocking layer 230, the color filter layer 235, and the protective layer 220 of the second substrate 2000 shown in FIG. 2. The bank structure 510 having the opening OP that corresponds to the first light emitting area LA1 and has the concave portion 515 may be formed on an upper surface of the substrate 500. In an embodiment, the bank structure 510 may correspond to the pixel defining layer 130 of the first substrate 1000 shown in FIG. 2. In another embodiment, the bank structure 510 may correspond to the partition wall 210 of the second substrate 2000 shown in FIG. 2.

In an embodiment, the concave portion 515 of the bank structure 510 may be formed by an etching process. For example, the concave portion 515 may be formed by wet etching, dry etching, laser etching, or the like.

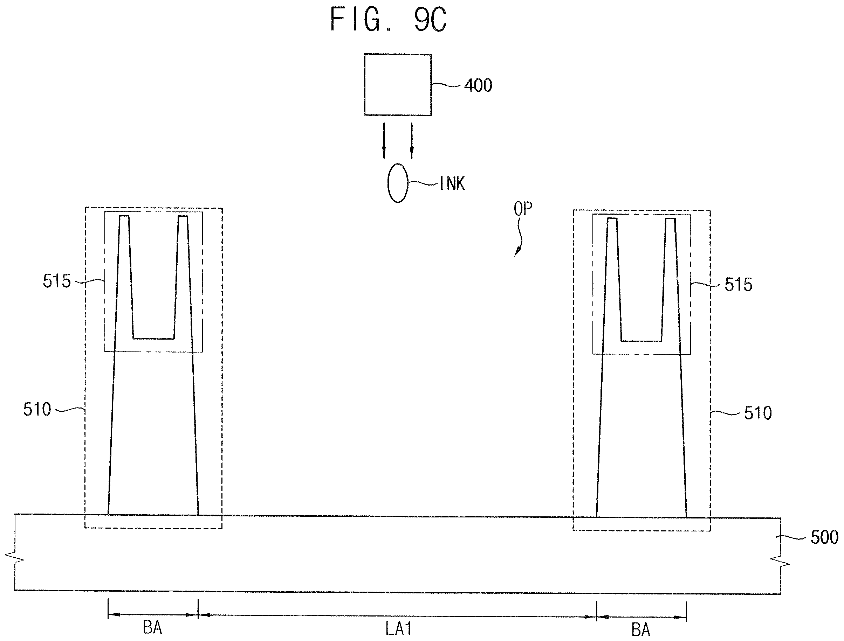

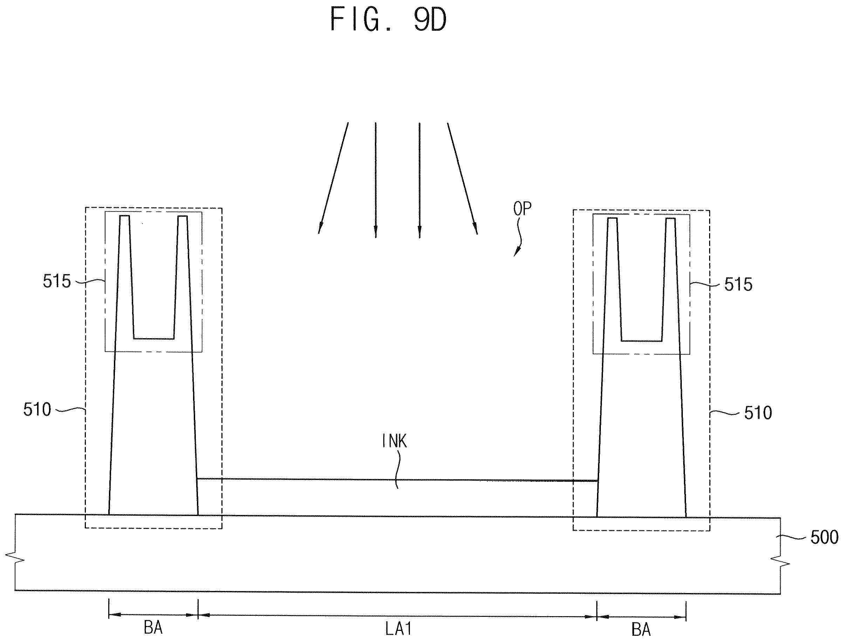

Referring to FIGS. 2, 9C and 9D, the inkjet device 400 may apply ink INK into the opening OP, and the ink INK may be cured thereafter. In an embodiment, the ink INK may include an organic light emitting material. In this case, the organic light emitting diode OLED including the organic light emitting material may be formed in the opening OP. In an embodiment, the ink INK may include the wavelength converting particles 215a of the color converting layer 215 shown in FIG. 2, a binder component, and a solvent. In this case, the color converting layer 215 may be formed in the opening OP. The applied ink INK may be dried and/or cured. The drying of the ink INK may be performed by heat and/or wind. The curing of the ink INK may be performed by thermal curing and/or photo curing (e.g., ultraviolet (UV) radiation).

The bank structure 510 having the concave portion 515 may accommodate ink that is erroneously applied by the inkjet device 400 in the ink jet process. Accordingly, a gap defect that may otherwise occur when forming a separate layer on the bank structure 510 may be prevented.

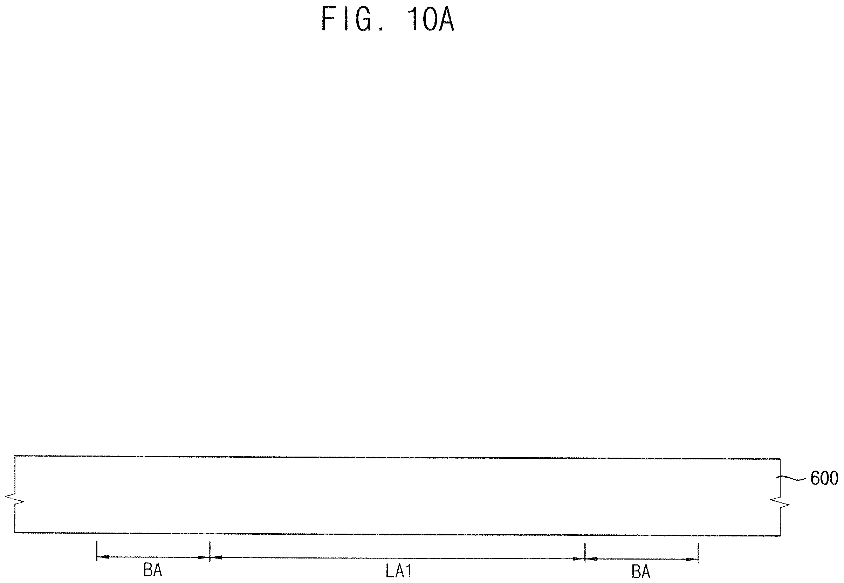

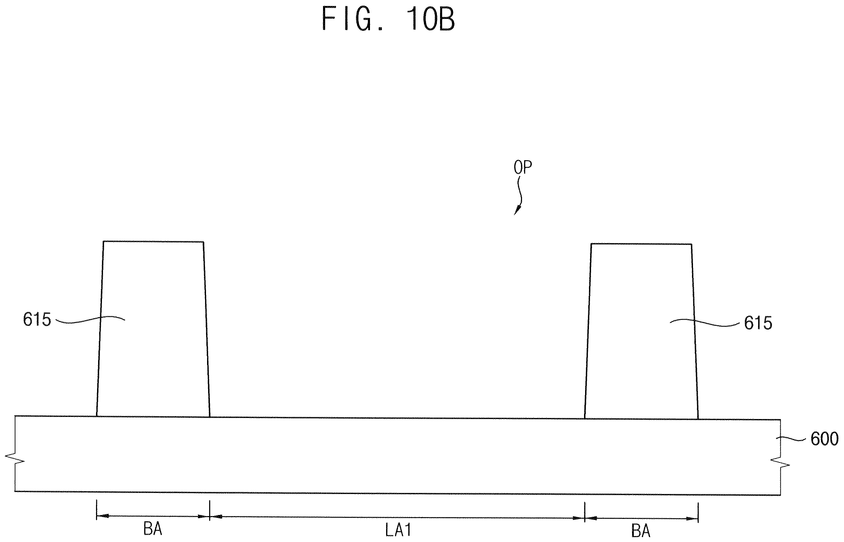

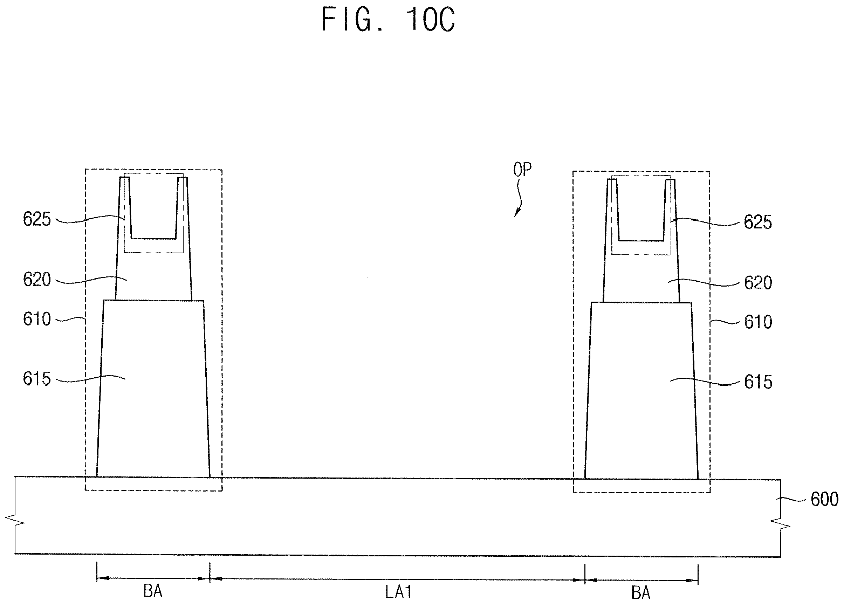

FIGS. 10A through 10E are diagrams illustrating a method of manufacturing a display device according to an embodiment of the present disclosure.

Referring to FIGS. 2, and 10A through 10C, the substrate 600 including the first light emitting area LA1 and the light blocking area BA that surrounds the first light emitting area LA1 may be prepared. In an embodiment, the substrate 600 may include the first base substrate 100 and the insulating layer 110 of the first substrate 1000 shown in FIG. 2. In another embodiment, the substrate 600 may include the second base substrate 240, the light blocking layer 230, the color filter layer 235, and the protective layer 220 of the second substrate 2000 shown in FIG. 2. The bank structure 610 having the opening OP that corresponds to the first light emitting area LA1 and have the concave portion 625 may be formed on an upper surface of the substrate 600. In an embodiment, the bank structure 610 may correspond to the pixel defining layer 130 of the first substrate 1000 shown in FIG. 2. In another embodiment, the bank structure 610 may correspond to the partition wall 210 of the second substrate 2000 shown in FIG. 2.

In an embodiment, the first portion 615 of the bank structure 610 may be formed on the light blocking area BA of the substrate 600, and the second portion 620 of the bank structure 610 that has the concave portion 625 may be formed on the first portion 615. In an embodiment, the second portion 620 having a flat top surface may be disposed on the first portion 615, and the concave portion 625 may be formed by etching the flat top surface of the second portion 620. The concave portion 625 may be formed by dry etching, wet etching, laser etching, or the like.

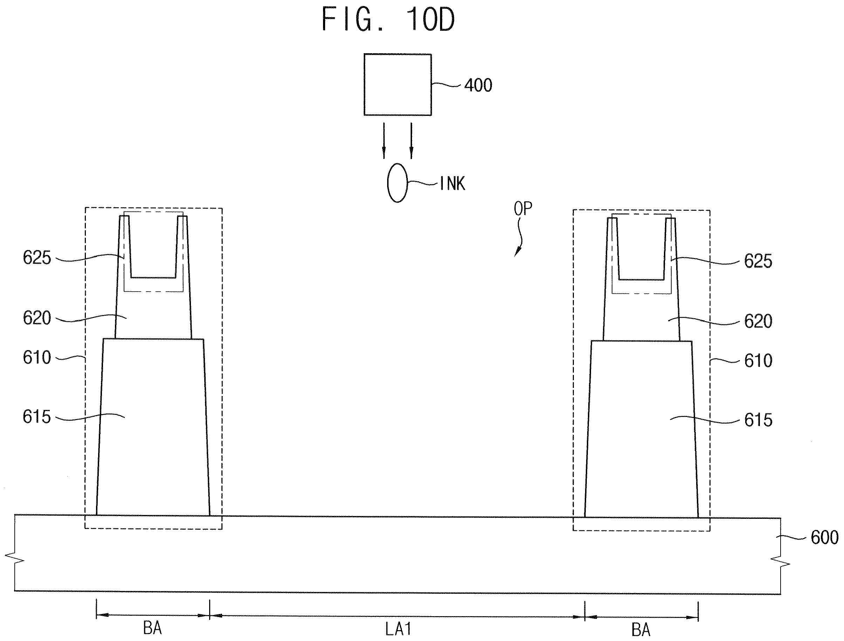

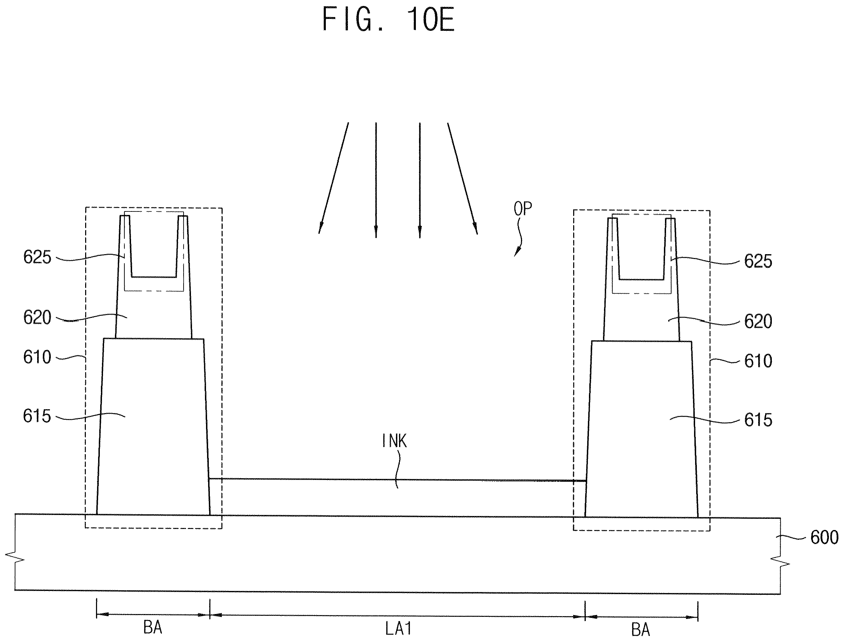

Referring to FIGS. 2, 10D and 10E, the inkjet device 400 may apply the ink INK into the opening OP, and the ink INK may be cured thereafter. In an embodiment, the ink INK may include an organic light emitting material. In this case, the organic light emitting diode OLED including the organic light emitting material may be formed in the opening OP. In an embodiment, the ink INK may include the wavelength converting particles 215a of the color converting layer 215 shown in FIG. 2. In this case, the color converting layer 215 may be formed in the opening OP. The applied ink INK may be dried and/or cured. The drying of the ink INK may be carried out by heat and/or wind. The curing of the ink INK may be performed by thermal curing and/or photo curing (e.g., ultraviolet (UV) radiation).

The bank structure 610 having the concave portion 625 may accommodate ink that is erroneously applied by the inkjet device 400 in the ink jet process. Accordingly, a gap defect that may otherwise occur when forming a separate layer on the bank structure 610 may be prevented.

The inventive concepts may be applied to any display device, and any electronic device including the display device. For example, the inventive concepts may be applied to a mobile phone, a smart phone, a tablet computer, a wearable electronic device, a virtual reality (VR) device, a television (TV), a digital TV, a three-dimensional (3D) TV, a personal computer (PC), a home appliance, a laptop computer, a personal digital assistant (PDA), a portable multimedia player (PMP), a digital camera, a music player, a portable game console, a navigation device, etc.

The foregoing is illustrative of some embodiments of the present disclosure and is not to be construed as limiting thereof. Although some embodiments of the present disclosure have been described, those skilled in the art will readily appreciate that modifications are possible in the disclosed embodiments without materially departing from the novel teachings and advantages of the present inventive concept. Accordingly, such modifications are intended to be included within the scope of the present inventive concept as defined in the claims. Therefore, it is to be understood that the foregoing is illustrative of various embodiments of the present disclosure and is not to be construed as limited to the specific embodiments disclosed herein, and that modifications to the disclosed embodiments, as well as other embodiments, are intended to be included within the scope of the present inventive concepts including the appended claims.

## Claims

1. A display device comprising:
a substrate including a light emitting area and a light blocking area that surrounds the light emitting area; and
a bank structure disposed in the light blocking area and having an opening that corresponds to the light emitting area,
wherein the bank structure has a concave portion on an upper surface.

2. A display device of claim 1, wherein:
(i) the concave portion reaches an upper surface of the substrate; or
(ii) the concave portion is spaced apart from an upper surface of the substrate.

3. A display device of claim 1 or claim 2, further comprising an organic light emitting diode disposed in the opening,
wherein the organic light emitting diode comprises:
a lower electrode;
a light emitting layer disposed on the lower electrode; and
an upper electrode disposed on the light emitting layer.

4. A display device of claim 1 or claim 2, further comprising a color converting layer disposed in the opening,
wherein the color converting layer comprises:
a wavelength converting particle; and
a resin portion.

5. A display device of claim 4, wherein the bank structure includes a light blocking material.

6. A display device of claim 5, further comprising:
a color filter layer overlapping the color converting layer; and
a light blocking layer overlapping the bank structure, optionally wherein:
the color filter layer is disposed between the color converting layer and the substrate, and the light blocking layer is disposed between the bank structure and the substrate.

7. A display device of claim 1, wherein the bank structure includes a first portion and a second portion that is disposed on the first portion and includes the concave portion.

8. A display device of claim 7, wherein:
(i) the concave portion reaches an upper surface of the first portion; or
(ii) the concave portion is spaced apart from an upper surface of the substrate.

9. A display device of claim 7 or claim 8, further comprising an organic light emitting diode disposed in the opening,
wherein the organic light emitting diode comprises:
a lower electrode;
a light emitting layer disposed on the lower electrode; and
an upper electrode disposed on the light emitting layer.

10. A display device of claim 7 or claim 8, further comprising a color converting layer disposed in the opening,
wherein the color converting layer including:
a wavelength converting particle; and
a resin portion.

11. A display device of claim 10, wherein the bank structure includes a light blocking material.

12. A display device of claim 11, further comprising:
a color filter layer overlapping the color converting layer; and
a light blocking layer overlapping the bank structure, optionally wherein:
the color filter layer is disposed between the color converting layer and the substrate, and the light blocking layer is disposed between the bank structure and the substrate.

13. A method of manufacturing a display device, the method comprising:
preparing a substrate including a light emitting area and a light blocking area that surrounds the light emitting area;
forming a bank structure having an opening on the substrate, wherein the opening corresponds to the light emitting area of the substrate;
forming a concave portion on an upper surface of the bank structure;
applying an ink into the opening; and
drying or curing the ink.

14. A method of claim 13, wherein:
(i) the ink contains an organic light emitting material; or
(ii) the ink contains a wavelength converting particle.

15. A method of claim 13 claim 14, wherein forming the bank structure comprises:
forming a first portion of the bank structure on the substrate; and
forming a second portion of the bank structure including the concave portion on the first portion.
